# DEMANDE DE BREVET EUROPEEN

(11) **EP 1 085 651 A1**
(43) Date de publication de la demande: **21.03.2001**
(21) Numéro de dépôt: 00203153.2
(22) Date de dépôt: 12.09.2000
(51) Int. Cl.: H03D 1/04, H03D 3/00

(54) **Démodulateur utilisant sélection d'un harmonique au niveau de fréquence intermédiare pour démoduler, et procédé**

(30) Priorité: 14.09.1999 FR 9911481
(71) Demandeur: Koninklijke Philips Electronics N.V., 5621 BA Eindhoven (NL)
(72) Inventeur: Greer, Nigel, Société Civile S.P.I.D., 75008 Paris (FR)
(74) Mandataire: Chaffraix, Jean

(57) **Abrégé**

La présente invention concerne un procédé pour démoduler un signal (I,Q) présentant une composante principale et des harmoniques.
Selon l'invention, ce procédé inclut les étapes suivantes :
. sélection d'un des harmoniques, et
. démodulation de l'harmonique sélectionné.
L'invention rend possible l'élimination, sans altération des données véhiculées par le signal démodulé SD, d'une composante parasite introduite dans ledit signal SD par la démodulation.
Application : Radiotéléphones.

## Description

La présente invention concerne un procédé pour démoduler un signal présentant une composante principale et des harmoniques.

De tels procédés sont couramment utilisés au sein d'appareils de réception de signaux radioélectriques, qui comportent généralement :
. un système d'antenne permettant la réception d'un signal radioélectrique, et sa transformation en un signal électronique, dit signal radio, ayant une fréquence radio,
. un dispositif de conversion de fréquence destiné à délivrer un signal, dit intermédiaire, ayant une fréquence intermédiaire, représentatif du signal radio, et
. un dispositif de démodulation du signal intermédiaire.

Dans les appareils de réception connus, le signal intermédiaire présente une composante principale et des harmoniques et est soumis à un filtrage passe-bande avant sa démodulation, filtrage qui a pour effet de supprimer les harmoniques. La composante principale est ainsi sélectionnée car elle possède une plus grande amplitude et est de ce fait considérée comme plus significative que les harmoniques, et c'est elle qui fait l'objet d'une démodulation.

Un des efforts majeurs dans l'industrie électronique tend à réduire l'encombrement des appareils qu'elle produit, dans un triple but de réduction des coûts de production, de réduction de la consommation énergétique et de confort pour l'utilisateur du fait du poids et de l'inconfort réduit que présentent les appareils ainsi miniaturisés.
Le convertisseur de fréquence et le dispositif de démodulation sont donc de plus en plus souvent réalisés sous la forme de circuits intégrés, voire rassemblés en un unique circuit intégré. La réalisation sous forme intégrée du convertisseur de fréquence impose que la valeur de la fréquence intermédiaire soit relativement basse. Or, des phénomènes de fuite se produisent entre l'entrée et la sortie du démodulateur, qui provoquent l'apparition, dans le signal de sortie du démodulateur, d'une composante parasite ayant la fréquence de son signal d'entrée. Si les plages de variation des fréquences des signaux d'entrée et de sortie du démodulateur se chevauchent, il est impossible de filtrer ladite composante parasite sans altérer le signal démodulé. Cette composante parasite dégrade sensiblement les performances de l'appareil, particulièrement dans les cas où le signal radio reçu est peu puissant.
A titre d'exemple, dans un radiotéléphone conforme à la norme DECT incluant un convertisseur de fréquence intégré, la fréquence intermédiaire centrale est choisie égale à 864kHz, ce qui implique que la fréquence instantanée du signal d'entrée du démodulateur varie entre 400 et 1300MHz, alors que la plage de variation de la fréquence du signal démodulé va de 0 à 700kHz.
Par ailleurs, les phénomènes de fuite étant principalement dus à des appairages imparfaits entre divers éléments constituant le démodulateur, et étant fortement liés à des imperfections du procédé de réalisation utilisé pour produire le démodulateur, l'ampleur de ces phénomènes de fuite peut varier considérablement d'un démodulateur à un autre, ce qui provoque des baisses aléatoires du rendement de la production des démodulateurs connus.

La présente invention a pour but de remédier à ces inconvénients en proposant un procédé de démodulation qui assure que les plages de variation de fréquence des signaux d'entrée et de sortie du démodulateur ne se recoupent pas.

En effet, un procédé conforme au paragraphe introductif est caractérisé selon l'invention en ce qu'il inclut les étapes suivantes :
. sélection d'un des harmoniques, et
. démodulation de l'harmonique sélectionné.

Conformément à ce procédé, la composante parasite introduite par le démodulateur dans le signal démodulé aura pour fréquence centrale celle de l'harmonique sélectionné. Pour reprendre l'exemple du radiotéléphone de type DECT décrit ci-dessus, la fréquence centrale du troisième harmonique, qui est l'harmonique le plus proche de la composante principale du signal intermédiaire, est de l'ordre de 2,6MHz, sa fréquence instantanée variant entre 1,3 et 3,9MHz.
Le procédé selon l'invention rend donc possible l'élimination, par exemple au moyen d'un filtrage passe-bas, de la composante parasite, sans altération des données véhiculées par le signal démodulé.

De manière générale, l'invention peut être mise en oeuvre dans tous types d'applications dans lesquelles un démodulateur est susceptible de provoquer des phénomènes de fuite. Ainsi, l'invention concerne également un dispositif de démodulation d'un signal présentant une composante principale et des harmoniques, comportant :
. un filtre passe-bande, destiné à recevoir ledit signal et à délivrer un signal filtré,
. un démodulateur destiné à recevoir le signal filtré et à délivrer un signal démodulé, dispositif caractérisé en ce que le filtre passe-bande possède un gabarit qui est calé sur une fréquence centrale de l'un des harmoniques.

Dans un des ses modes de mise en oeuvre les plus avantageux, l'invention concerne également un récepteur de signaux radioélectriques, comportant :
. un système d'antenne permettant la réception d'un signal radioélectrique, et sa transformation en un signal électronique, dit signal radio, ayant une fréquence radio,
. un dispositif de conversion de fréquence destiné à délivrer un signal, dit intermédiaire, ayant une fréquence intermédiaire, représentatif du signal radio, et
. un dispositif de démodulation du signal intermédiaire, récepteur caractérisé en ce que le dispositif de démodulation est tel que décrit ci-dessus.

L'invention sera mieux comprise à l'aide de la description suivante, faite à titre d'exemple non-limitatif et en regard des dessins annexés, dans lesquels :
- la figure 1 est un schéma fonctionnel partiel décrivant un récepteur de signaux radioélectriques qui met en oeuvre l'invention,
- la figure 2 est un diagramme spectral qui représente la composition fréquentielle d'un signal présent dans un tel récepteur, et
- la figure 3 est un diagramme spectral qui illustre la composition fréquentielle d'un autre signal présent dans un tel récepteur.

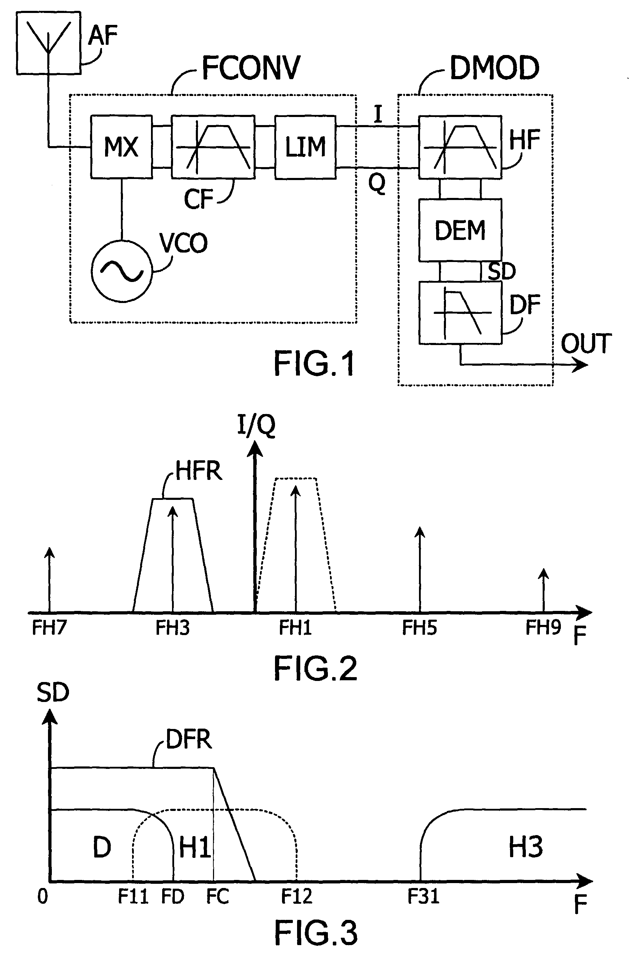

La figure 1 représente schématiquement un récepteur de signaux radioélectriques, comportant :
. un système d'antenne AF permettant la réception d'un signal radioélectrique, et sa transformation en un signal électronique, dit signal radio, ayant une fréquence radio,
. un dispositif de conversion de fréquence FCONV destiné à délivrer un signal (I,Q), dit intermédiaire, ayant une fréquence intermédiaire, représentatif du signal radio, et
. un dispositif de démodulation DMOD du signal intermédiaire (I,Q).
Le dispositif de conversion FCONV comporte ici un oscillateur VCO, et un mélangeur MX destiné à recevoir le signal radio et un signal délivré par l'oscillateur VCO. Le mélangeur MX délivre un signal, qui est filtré au moyen d'un filtre de sélection CF qui opère une sélection d'une composante particulière du signal de sortie du mélangeur MX. Le filtre de sélection CF est en général un filtre passe-bande du type polyphasé qui possède un gabarit qui est calé sur la fréquence centrale de la composante à sélectionner. Cette fréquence centrale constitue alors la fréquence intermédiaire. Lorsque le filtre de sélection CF est réalisé sous forme intégrée, il est composé d'éléments qui présentent des résistances et capacités parasites qui produisent des effets néfastes au comportement du filtre, effets qui sont d'autant plus significatifs que la fréquence sur laquelle est calé le gabarit du filtre est élevée. Ces effets néfastes sont particulièrement sensibles lorsque le signal à filtrer est très bruité, ce qui est le cas en l'espèce puisqu'il provient du système d'antenne AF via le mélangeur MX. De plus, la consommation énergétique du filtre de sélection CF sera d'autant plus élevée que la fréquence intermédiaire sera élevée. On choisit donc usuellement une fréquence intermédiaire relativement basse. A titre d'exemple, dans un récepteur de type DECT, on choisit de caler le gabarit du filtre sur une fréquence égale à 864kHz, soit la moitié d'une largeur de bande d'un canal, fixée à 1,728MHz.
Le filtre de sélection CF délivre un signal de sortie, qui a une forme sinusoïdale, à un limiteur LIM qui réalise une forte amplification dudit signal de sortie, et délivre ainsi un signal intermédiaire (I,Q) qui a une forme carrée. La transformation d'un signal sinusoïdal en un signal carré est opérée en faisant travailler des amplificateurs en saturation, ce qui a pour effet d'introduire des harmoniques dans le signal intermédiaire (I,Q), en plus de la composante principale sélectionnée par le filtre de sélection CF.
Le dispositif de démodulation DMOD comporte un filtre passe-bande HF, destiné à recevoir le signal intermédiaire (I,Q) et à délivrer un signal filtré, et un démodulateur DEM destiné à recevoir le signal filtré et à délivrer un signal démodulé SD, dont une composante principale contient des données véhiculées par ledit signal. Le démodulateur DEM provoque des phénomènes de fuite qui introduisent au sein du signal démodulé SD une composante parasite ayant une fréquence centrale égale à la fréquence sur laquelle est calé le gabarit du filtre passe-bande HF. Cette composante parasite peut dégrader sensiblement les performances de l'appareil, particulièrement dans les cas où le signal radio reçu est peu puissant.
Le dispositif de démodulation DMOD comporte enfin un filtre de données DF, qui est ici un filtre passe-bas. En effet, l'invention rend possible de séparer la composante principale du signal démodulé SD de la composante parasite introduite dans ledit signal par les phénomènes de fuite. Le dispositif de démodulation DMOD délivre ainsi un signal de sortie OUT qui est débarrassé de la composante parasite, sans pour autant que les données qu'il véhicule aient été altérées.

La figure 2 est un diagramme spectral qui représente la composition fréquentielle du signal intermédiaire (I,Q). Ce signal comporte une composante principale dont la fréquence centrale est FH1, et des harmoniques dont les fréquences centrales sont FH3, FH5, FH7, FH9, etc. Dans les démodulateurs connus, le filtre passe-bande HF a un gabarit, représenté ici en traits pointillés, qui est calé sur la fréquence centrale FH1 de la composante principale du signal intermédiaire (I,Q). Dans le démodulateur conforme à la présente invention, le gabarit HFR du filtre passe-bande HF est calé sur la fréquence centrale de l'un des harmoniques. Dans l'exemple décrit ici, il s'agit de la fréquence centrale FH3 du troisième harmonique. Ce choix est lié au fait que le troisième harmonique est celui dont l'amplitude est la plus grande et dont la fréquence est la plus faible. Dans le cas du récepteur DECT cité en exemple précédemment, la fréquence centrale H1 de la composante principale est égale à 864kHz, tandis que la fréquence centrale H3 du troisième harmonique est de l'ordre de 2,6MHZ.

La figure 3 est un diagramme spectral qui représente les plages de variations possibles des fréquences instantanées de différentes composantes que présente le signal démodulé SD. Le domaine D représente la plage de variation de la fréquence instantanée de la composante principale du signal démodulé, composante principale qui véhicule des données utiles. Ce domaine D s'étend de la fréquence nulle à une fréquence FD.
Un domaine H1, représenté en traits pointillés, représente la plage de variation de la fréquence instantanée de la composante parasite qu'introduit le démodulateur DEM dans le signal démodulé SD au sein des dispositifs de démodulation connus, dans lesquels le gabarit du filtre passe-bande est calé sur la fréquence centrale H1 de la composante principale du signal intermédiaire. Ce domaine H1 s'étend d'une fréquence F11 à une fréquence F12. Dans le cas du récepteur DECT cité en exemple précédemment, la fréquence FD est égale à 700kHz, tandis que les fréquences F11 et F12 sont respectivement de l'ordre de 400 et 1300kHz. Dans un tel cas de figure, les plages de variation des fréquences instantanées des signaux d'entrée et de sortie du démodulateur se chevauchent, et il est impossible de filtrer la composante parasite sans altérer les informations que le signal démodulé doit véhiculer, par exemple au moyen d'un filtre passe-bas dont un gabarit DFR est représenté sur la figure. Il apparaît clairement qu'on ne pourra trouver de fréquence de coupure FC suffisamment basse pour éliminer toute trace de la composante parasite sans risquer d'altérer le contenu du domaine D.
Un domaine H3 représente la plage de variation de la fréquence instantanée de la composante parasite qu'introduit le démodulateur DEM dans le signal démodulé SD au sein d'un dispositif de démodulation conforme à l'invention, dans lequel le gabarit du filtre passe-bande est calé sur la fréquence centrale FH3 du troisième harmonique du signal intermédiaire. Ce domaine H3 s'étend d'une fréquence F31 à une fréquence F32, non représentée sur la figure. Dans le cas du récepteur DECT cité en exemple précédemment, les fréquences F31 et F32 sont respectivement de l'ordre de 1,3 et 3,9MHz. Dans un tel cas de figure, les plages de variation des fréquences instantanées des signaux d'entrée et de sortie du démodulateur ne se chevauchent pas, et il est possible de filtrer la composante parasite sans altérer les informations que le signal démodulé doit véhiculer, par exemple au moyen d'un filtre passe-bas dont un gabarit DFR est représenté sur la figure. Il apparaît clairement qu'on pourra trouver une fréquence de coupure FC suffisamment basse pour éliminer toute trace de la composante parasite sans risquer d'altérer le contenu du domaine D. On pourra par exemple choisir FD égale à 800kHz.

## Revendications

1. Procédé pour démoduler un signal présentant une composante principale et des harmoniques, caractérisé en ce qu'il inclut les étapes suivantes :
. sélection d'un des harmoniques, et
. démodulation de l'harmonique sélectionné.

2. Procédé conforme à la revendication 1, caractérisé en ce que l'harmonique sélectionné est le troisième harmonique.

3. Procédé conforme à la revendication 1, caractérisé en ce qu'il comporte en outre une étape de filtrage passe-bas du signal résultant de la démodulation de l'harmonique sélectionné.

4. Dispositif de démodulation d'un signal présentant une composante principale et des harmoniques, comportant :
. un filtre passe-bande, destiné à recevoir ledit signal et à délivrer un signal filtré,
. un démodulateur destiné à recevoir le signal filtré et à délivrer un signal démodulé, dispositif caractérisé en ce que le filtre passe-bande possède un gabarit qui est calé sur une fréquence centrale de l'un des harmoniques.

5. Dispositif de démodulation selon la revendication 4, caractérisé en ce que le gabarit du filtre passe-bande est calé sur la fréquence centrale du troisième harmonique.

6. Dispositif de démodulation selon la revendication 4, caractérisé en ce qu'il comporte en outre un filtre passe-bas, disposé en aval du démodulateur, dont la fréquence de coupure est inférieure à la fréquence sur laquelle est calé le gabarit du filtre passe-bande.

7. Récepteur de signaux radioélectriques, comportant :
. un système d'antenne permettant la réception d'un signal radioélectrique, et sa transformation en un signal électronique, dit signal radio, ayant une fréquence radio,
. un dispositif de conversion de fréquence destiné à délivrer un signal, dit intermédiaire, ayant une fréquence intermédiaire, représentatif du signal radio, et
. un dispositif de démodulation du signal intermédiaire,
récepteur caractérisé en ce que le dispositif de démodulation est conforme à la revendication 4.
